# EUROPÄISCHE PATENTANMELDUNG

(11) **EP 3 462 614 A1**
(43) Veröffentlichungstag der Anmeldung: **03.04.2019**
(21) Anmeldenummer: 17193789.9
(22) Anmeldetag: 28.09.2017
(51) Int. Cl.: H03K 17/10, H03K 17/12

(54) **OPTIMIERTE KASKODENSTRUKTUREN**

(71) Anmelder: Siemens Aktiengesellschaft, 80333 München (DE)
(72) Erfinder: Weiss, Jörg, 09224 Chemnitz (DE)

(57) **Zusammenfassung**

Es soll eine vereinfachte Kaskodenschaltungsanordnung mit zwei Kaskoden bereitgestellt werden. Daher wird eine Kaskodenschaltungsanordnung mit einer ersten Kaskode (K1), die ein erstes selbstleitendes Schaltelement (J1) in Serie mit einem selbstsperrenden Schaltelement (M1) aufweist, und einem zweiten selbstleitenden Schaltelement (J2) zur Verfügung gestellt. Das selbstsperrende Schaltelement (M1) ist das einzige selbstsperrende Schaltelement der Kaskodenschaltungsanordnung. Darüber hinaus bildet das zweite selbstleitende Schaltelement (J2) mit dem einzigen selbstsperrenden Schaltelement (M1) eine von der ersten verschiedene zweite Kaskode.

## Beschreibung

Die vorliegende Erfindung betrifft eine Kaskodenschaltungsanordnung mit einer Kaskode, die ein erstes selbstleitendes Schaltelement in Serie mit einem selbstsperrenden Schaltelement aufweist und mit einem zweiten selbstleitenden Schaltelement. Darüber hinaus betrifft die vorliegende Erfindung eine Steuervorrichtung mit einer derartigen Kaskodenschaltungsanordnung.

Im Zuge der Weiterentwicklung von modernen Halbleitern (SiC und GaN) werden zum Teil selbstleitende Bauteile (Depletion-Mode-JFETs) entwickelt. In der Anwendung werden aber in der Regel selbstsperrende Halbleiterstrukturen (Enhancement-Mode) benötigt, um Betriebsfälle wie Start, Verlust des Ansteuersignals und dergleichen zu beherrschen.

Sind aber hohe Schaltfrequenzen beziehungsweise höhere Wirkungsgrade notwendig, so werden häufig selbstleitende GaN-Schalter als Sperrschicht-Feldeffekttransistoren (JFET) benutzt. Bei entsprechendem Einsatz in Schaltungen muss vor dem Zuschalten der Drain-Source-Spannung das Gatesignal zum Abschalten bereitgestellt werden, da ansonsten die Gefahr des Kurzschlusses im Leistungskreis besteht. Darüber hinaus kommt es bei einem JFET bei Verlust der Ansteuerspannung zu einem Kurzschluss von Drain und Source. Daher besteht der Wunsch nach einem Enhancement-Mode (selbstsperrend) GaN-Schalter.

Für eine selbstsperrende Halbleiterstruktur wird heute als bevorzugte Schaltungslösung häufig eine Kaskodenstruktur benutzt, die beispielsweise aus einer Serienschaltung eines selbstsperrenden MOSFET und des selbstleitenden JFET besteht. Allerdings erzeugt der MOSFET in dieser Kombination zusätzliche Verluste, vergrößert den gesamten Platzbedarf, erhöht die Gesamtkosten und beeinflusst zum Teil auch das Schaltverhalten.

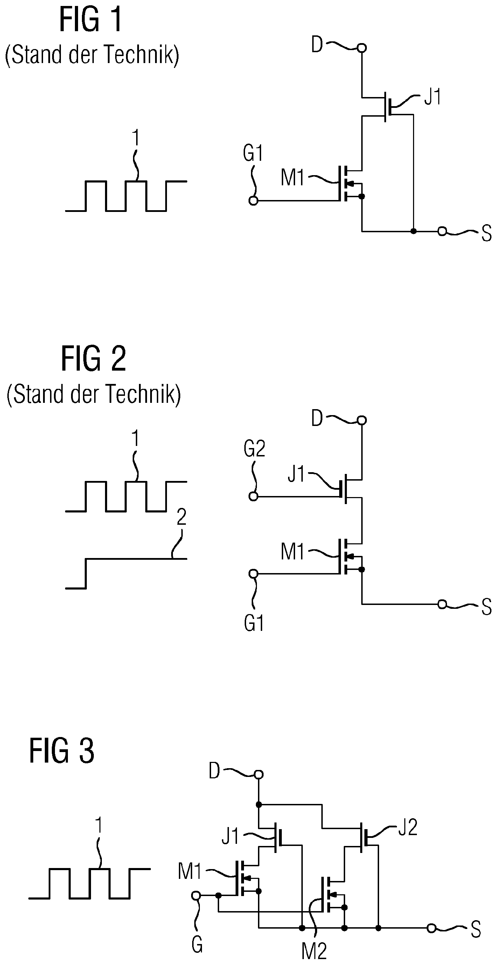

Eine Kaskode kann prinzipiell auch mit Röhren und npn-Bipolartransistoren aufgebaut werden. Um aber höhere Spannungen schneller schalten zu können, werden in der Regel Kaskoden gemäß FIG 1 mit einem selbstleitenden Schaltelement (häufig ein JFET) in Serie mit einem selbstsperrenden Schaltelement (meist ein MOSFET) betrieben. Eine derartige Kaskode stellt ein komplexes Schaltelement dar und besitzt Drain D, Source S und Gate G. Zwischen Drain D und Source S sind das selbstleitende Schaltelement J1 und das selbstsperrende Schaltelement M1 in Serie geschaltet. Bei dem selbstleitenden Schaltelement J1 handelt es sich z.B. um einen JFET und bei dem selbstsperrenden Schaltelement M1 handelt es sich z.B. um einen MOSFET. Die Steuerelektrode beziehungsweise Gate von J1 ist an Source S geschaltet. Das Gate G der Kaskode entspricht der Steuerelektrode beziehungsweise dem Gate von M1. An Gate G wird beispielsweise ein Schaltsignal 1 angelegt. Es ist also ein selbstleitendes Schaltelement J1 genau einem selbstsperrenden Schaltelement M1 zugeordnet. Mit anderen Worten, in der Kaskode entspricht die Anzahl an JFETs der Anzahl an MOSFETs.

Im Betrieb wird der selbstsperrende MOSFET M1 als Schalter benutzt und der selbstleitende JFET J1 bekommt sein Steuersignal aus der Differenz des Drainpotentials vom MOSFET M1 zum Gate des JFET J1. Das Gate ist hier fest auf Source S gelegt. Diese Differenz wird negativ, wenn der MOSFET M1 sperrt. In diesem Zustand sperrt auch der selbstleitende JFET J1. Im leitenden Zustand addieren sich die Leitungswiderständer R_{DSon} der beiden Schaltelemente.

Zu der Kaskode gemäß FIG 1 gibt es eine alternative Ausführungsform gemäß FIG 2. Hier besitzt die Kaskode wiederum Drain D und Source S, aber zwei Gates, nämlich G1 und G2. Die Leistungspfade des selbstsperrenden Schaltelements M1 und des selbstleitenden Schaltelements J1 sind wiederum zwischen Drain D und Source S in Serie geschaltet. Das erste Gate G1 entspricht dem Gate des MOSFET beziehungsweise selbstsperrenden Schaltelements M1 und das zweite Gate G2 entspricht dem Gate des JFET beziehungsweise selbstleitenden Schaltelements J1. An das Gate G1 wird ein Ersteinschaltsignal 2 und an das zweite Gate G2 das Schaltsignal 1 gelegt. Im leitenden Zustand addieren sich auch hier die Einschaltwiderstände R_{DSon} der beiden Schaltelemente.

Hier wird zur Ansteuerung eine spezielle Treiberschaltung verwendet, die das erforderliche Gatesignal für den JFET J1 bereitstellt. Zum erstmaligen Zuschalten (Erhalten des sperrenden Zustands ohne Ansteuersignal) wird der MOSFET M1 und das Erstanschaltsignal 2 benutzt. Der MOSFET M1 wird dauerhaft durchgeschaltet, sobald das Ansteuersignal beziehungsweise Schaltsignal 1 für den JFET J1 bereit steht. Nachfolgend muss der MOSFET M1 nur noch den Strom leiten. Die Schalteigenschaften der Kaskode werden also teilweise durch den MOSFET bestimmt.

Wird eine höhere Stromtragfähigkeit des Gesamtschalters gefordert, werden Kaskodenstrukturen gemäß FIG 1 oder FIG 2 parallel geschaltet, wie dies in den FIG 3 und 4 angedeutet ist. In diesen Beispielen sind jeweils zwei Kaskoden parallel geschaltet.

Die Parallelschaltung gemäß FIG 3 entspricht einer Parallelschaltung von zwei Kaskoden gemäß FIG 1. Die zweite Kaskode mit dem selbstleitenden Schaltelement J2 und dem selbstsperrenden Schaltelement M2 ist gleich aufgebaut wie die erste Kaskode mit dem selbstleitenden Schaltelement J1 und dem selbstsperrenden Schaltelement M1 gemäß FIG 1. Drain jeder Kaskode ist zusammengeschaltet zu einem gemeinsamen Drain D, Source jeder Kaskode ist zusammengeschaltet zu einem gemeinsamen Source S und Gate jeder Kaskode ist zusammengeschaltet zu einem gemeinsamen Gate G. Die Schalteigenschaften entsprechen im Wesentlichen denen des Beispiels von FIG 1.

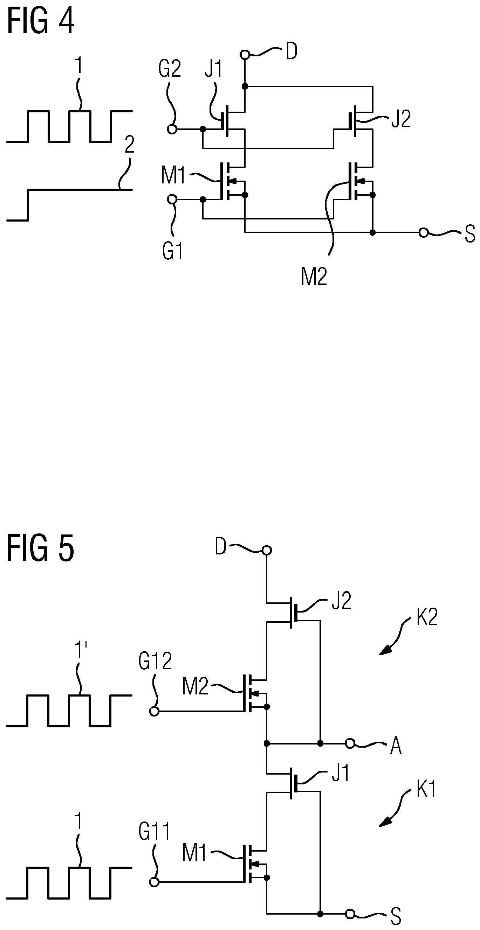

Alternativ kann auch eine Parallelschaltung von Kaskoden gemäß FIG 4 basierend auf zwei parallelen Kaskoden jeweils gemäß FIG 2 realisiert werden. Die erste Kaskode mit den Schaltelementen J1 und M1 ist gleich aufgebaut wie die parallele Kaskode mit den Schaltelementen J2 und M2. Drain jeder Einzelkaskode ist zusammengeführt zu einem gemeinsamen Drain D, Source jeder Einzelkaskode ist zusammengeführt zu einem gemeinsamen Source S, die Gates der selbstsperrenden Schaltelemente M1 und M2 sind zusammengeschaltet zu dem gemeinsamen Gate G1 und die Gates der selbstleitenden Schaltelemente J1 und J2 sind zusammengeschaltet zu dem gemeinsamten zweiten Gate G2. Auch hier liegt das Ersteinschaltsignal 2 an dem gemeinsamen ersten Gate G1 und das Schaltsignal 1 an dem gemeinsamen zweiten Gate G2 an. Die Schalteigenschaften entsprechen im Wesentlichen denen des Beispiels von FIG 2.

Kaskodenstrukturen gemäß den FIG 1 und 2 können auch in Serie zu Halbbrückenschaltungen kombiniert werden, die heute üblicherweise in Stromrichtern oder Schaltnetzteilen höherer Leistung eingesetzt werden. Ein Beispiel einer solchen Halbbrückenschaltung ist in FIG 5 wiedergegeben. Die Schaltung entspricht im Wesentlichen einer Serienschaltung von zwei Kaskoden K1 und K2 jeweils entsprechend FIG 1. Drain der ersten Kaskode K1 und Source der zweiten Kaskode K2 bilden einen Ausgangsknoten A beziehungsweise eine entsprechende Phase. Drain der zweiten Kaskode K2 bildet Drain D der Gesamtschaltung und Source der ersten Kaskode K1 bildet Source S der Gesamtschaltung. Gate G11 bildet den ersten Steuereingang der ersten Kaskode K1 der Halbbrückenschaltung und Gate G12 bildet den zweiten Steuereingang der zweiten Kaskode K2 der Halbbrückenschaltung. Gate G11 wird gespeist durch ein Schaltsignal 1 und Gate 12 durch ein Schaltsignal 1'.

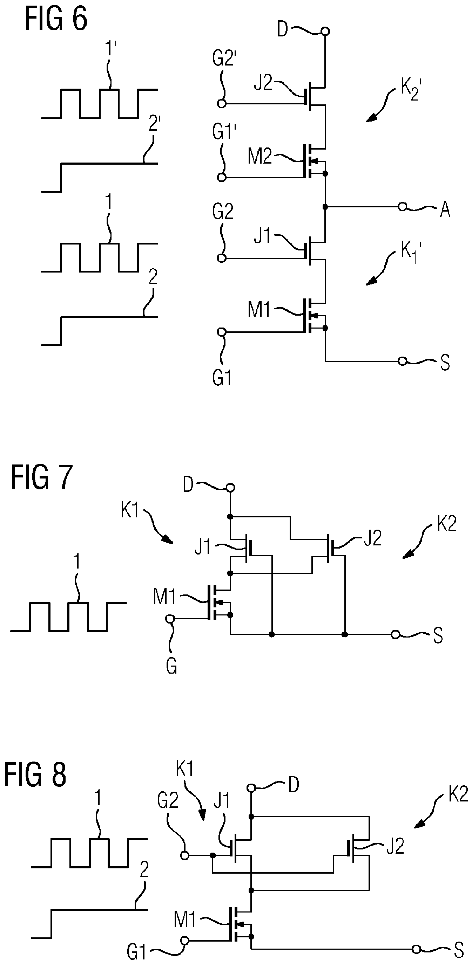

In ähnlicher Weise kann entsprechend FIG 6 auch eine Halbbrückenschaltung mit zwei Kaskoden K1' und K2', die jeweils einer Kaskode gemäß FIG 2 entsprechen, realisiert werden. Ein gemeinsamer Knoten von Drain der ersten Kaskode K1' und Source der zweiten Kaskode K2' bilden wiederum den Ausgang A. Das erste Gate G1 der ersten Kaskode K1', mit dem das selbstsperrende Schaltelement beziehungsweise der MOSFET M1 gesteuert wird, wird mit dem Ersteinschaltsignal 2 gespeist. Das zweite Gate G2, mit dem das selbstleitende Schaltelement beziehungsweise der JFET J1 gesteuert wird, wird mit dem Schaltsignal 1 gespeist. In gleicher Weise wird das erste Gate G1' der zweiten Kaskode K2' mit dem Ersteinschaltsignal 2' und das zweite Gate G2' der zweiten Kaskode K2' mit dem Schaltsignal 1' gespeist. Bei beiden Halbbrückenschaltungen gemäß den FIG 5 und 6 sowie bei beiden Parallelschaltungen gemäß den FIG 3 und 4 werden jeweils zwei JFETs und zwei MOSFETs benötigt. Die Einschaltwiderstände R_{DSon} der jeweiligen Schalter addieren sich in den Serienschaltungen. Die Schalteigenschaften der jeweiligen gesamten Kaskode werden nur durch die jeweiligen JFETs bestimmt. Es besteht ein erheblicher Platzbedarf, denn pro Schaltzweig in der Parallelschaltung und in der Halbbrückenschaltung sind immer zwei Chips notwendig.

Aus der Druckschrift DE 10 2006 029 928 B3 ist eine elektronische Schalteinrichtung mit zumindest zwei Halbleiterschaltelementen bekannt. Dort ist eine Kaskode gemäß FIG 2 dargestellt.

Die Aufgabe der vorliegenden Erfindung besteht darin, eine Kaskodenschaltungsanordnung mit mehreren Kaskoden bereitzustellen, die einen verringerten Platzbedarf besitzt.

Erfindungsgemäß wird diese Aufgabe durch eine Kaskodenschaltungsanordnung gemäß Anspruch 1 gelöst. Vorteilhafte Weiterbildungen der Erfindung ergeben sich aus den Unteransprüchen.

Gemäß der Erfindung wird demnach eine Kaskodenschaltungsanordnung mit einer ersten Kaskode, die ein erstes selbstleitendes Schaltelement in Serie mit einem selbstsperrenden Schaltelement aufweist und einem zweiten selbstleitenden Schaltelement bereitgestellt. Die Kaskodenschaltung ist eine Serienschaltung von zwei Schaltelementen und insbesondere Transistoren. Vorliegend werden ein selbstleitendes und ein selbstsperrendes Schaltelement in Reihe geschaltet, sodass sich in Summe eine selbstsperrende Charakteristik ergibt. Weiterhin besitzt die Kaskodenschaltungsanordnung ein zweites selbstleitendes Schaltelement. Dieses zweite selbstleitende Schaltelement ist für eine zweite Kaskode vorgesehen, die von der ersten Kaskode verschieden ist.

Das selbstsperrende Schaltelement ist das einzige selbstsperrende Schaltelement der Kaskodenschaltungsanordnung. Darüber hinaus bildet das zweite selbstleitende Schaltelement mit dem einzigen selbstsperrenden Schaltelement eine von der ersten verschiedene zweite Kaskode der Kaskodenschaltungsanordnung. Die Kaskodenschaltungsanordnung besitzt also ein einziges selbstleitendes Schaltelement und zwei selbstleitende Schaltelemente, von denen jedes mit dem einzigen selbstsperrenden Schaltelement jeweils eine separate Kaskode bildet. Damit werden für die zwei Kaskoden weniger selbstsperrende Schaltelemente benötigt als bei konventionellen Kaskodenschaltungen mit zwei Kaskoden. Insgesamt ist also die Anzahl der selbstsperrenden Schaltelemente in der Kaskodenschaltungsanordnung kleiner als die Anzahl der selbstleitenden Schaltelemente.

Die Kaskodenschaltungsanordnung kann Teil eines Kaskodenschaltungssystems sein. Ein solches Kaskodenschaltungssystem kann also die Kaskodenschaltungsanordnung und weitere Schaltelemente, insbesondere mindestens eine weitere Kaskodenschaltungsanordnung und/oder mindestens eine weitere Kaskode enthalten. Wesentlich ist nur, dass nicht für jede Kaskode ein separates selbstsperrendes Schaltelement vorgesehen sein muss.

Bei einer Ausführungsform der Kaskodenschaltungsanordnung ist das selbstsperrende Schaltelement ein MOSFET. MOSFETs zeichnen sich durch einen hohen Wirkungsgrad gegenüber anderen Schaltelementen aus.

In einer weiteren Ausgestaltung der Kaskodenschaltungsanordnung ist jedes selbstsperrende Schaltelement ein JFET. JFETs sind Sperrschicht-Feldeffekttransistoren, die sich durch ihre geringen Verluste und schnellen Schaltzeiten auszeichnen. Daher ist es vorteilhaft, eine Kaskode mit einem JFET auszustatten.

Darüber hinaus kann vorgesehen sein, dass jedes selbstsperrende Schaltelement ein GaN-Bauelement (Galliumnitrid) ist. Galliumnitrid-Feldeffekttransistoren erlauben beispielsweise höhere Schaltfrequenzen und erzielen in einem Netzteil einen höheren Wirkungsgrad als die üblicherweise in diesem Bereich eingesetzten und kostengünstigeren Feldeffekttransistoren auf Siliziumbasis. Auch für Hochfrequenzverstärker bilden die Galliumnitrid-Bauelemente deutliche Vorteile.

Eine weitere Ausgestaltung der Kaskodenschaltungsanordnung sieht vor, dass das erste selbstleitende Schaltelement und das zweite selbstleitende Schaltelement bezüglich ihrer Leistungspfade parallel geschaltet sind. Auf diese Weise lässt sich die Stromtragfähigkeit einer Kaskode erhöhen, wenn sie durch das selbstleitende Schaltelement limitiert ist. Im vorliegenden Fall muss aber der gesamte Strom durch das selbstsperrende Schaltelement fließen.

In einer weiteren Ausgestaltung kann vorgesehen sein, dass eine jeweilige Steuerelektrode jedes selbstleitenden Schaltelements an Source der Kaskodenschaltungsanordnung gelegt ist und eine Steuerelektrode des selbstsperrenden Schaltelements als einziger Steuereingang der Kaskodenschaltungsanordnung ausgebildet ist. Durch das Verbinden der Steuerelektrode des selbstleitenden Schaltelements mit Source der Kaskodenschaltungsanordnung ist das Steuerpotential des selbstleitenden Schaltelements festgelegt. Sobald die Differenz zwischen Source und Gate des selbstleitenden Schaltelements negativ wird, sperrt das selbstleitende Schaltelement. Dies ist genau dann der Fall, wenn das selbstsperrende Schaltelement ebenfalls sperrt. Das selbstleitende Schaltelement folgt also dem selbstsperrenden Schaltelement.

Alternativ kann bei den parallelen selbstleitenden Schaltelementen vorgesehen sein, dass eine jeweilige Steuerelektrode jedes selbstleitenden Schaltelements an einen ersten Steuereingang der Kaskodenschaltungsanordnung gelegt ist und eine Steuerelektrode des selbstsperrenden Schaltelements an einen von dem ersten Steuereingang verschiedenen zweiten Steuereingang der Kaskodenschaltungsanordnung gelegt ist. Mit diesen beiden Steuereingängen ist es möglich, das selbstleitende und das selbstsperrende Schaltelement jeweils unterschiedlich anzusteuern. Vorzugsweise wird das selbstsperrende Schaltelement für den Betrieb einmal eingeschaltet und bleibt während des Betriebs auch weiter eingeschaltet. Das eigentliche Schaltsignal für die Kaskodenschaltungsanordnung wird auf die Steuerelektrode des selbstleitenden Schaltelements gegeben. Das selbstsperrende Schaltelement gewährleistet hier also nur die Selbstsperrfähigkeit und das selbstleitende Schaltelement sorgt für das eigentliche Schalten.

Gemäß einer weiteren Alternative können das erste selbstleitende Schaltelement und das zweite selbstleitende Schaltelement bezüglich ihrer Leistungspfade in Serie geschaltet sein. Somit ist beispielsweise Drain des ersten selbstleitenden Schaltelements mit Source des zweiten selbstleitenden Schaltelements verbunden. Auf diese Weise kann eine Halbbrückenschaltung realisiert werden, wie sie beispielsweise bei Stromrichtern zur Ansteuerung von Elektromotoren benötigt werden.

Bei einer speziellen Ausgestaltung der in Serie geschalteten selbstleitenden Schaltelemente kann vorgesehen sein, dass eine Steuerelektrode des ersten selbstleitenden Schaltelements einen ersten Steuereingang der Kaskodenschaltungsanordnung, eine Steuerelektrode des zweiten selbstleitenden Schaltelements einen zweiten Steuereingang der Kaskodenschaltungsanordnung und eine Steuerelektrode des selbstsperrenden Schaltelements einen dritten Steuereingang zum An- und Abschalten der beiden selbstleitenden Schaltelemente darstellen. Auf diese Weise kann die gesamte Halbbrücke durch das selbstsperrende Schaltelement eingeschaltet und die einzelnen Halbbrückenzweige können durch die jeweiligen selbstleitenden Schaltelemente unabhängig voneinander geschaltet werden. Zur Erhöhung der Stromtragfähigkeit kann jedes selbstleitende Schaltelement mit einem jeweils parallel geschalteten selbstleitenden Schaltelement versehen sein. Somit genügt ein selbstsperrendes Schaltelement im vorliegenden Fall für vier selbstleitende Schaltelemente, um jeweils eine Kaskode zu bilden. Das Verhältnis von selbstleitenden Schaltelementen und selbstsperrendem Schaltelement beträgt hier also 4:1.

In einer bevorzugten Ausgestaltung wird eine Steuervorrichtung für einen Elektromotor mit einer Kaskodenschaltungsanordnung der genannten Art realisiert. Die Kaskodenschaltungsanordnung kann die oben geschilderten Varianten besitzen. Auf diese Weise kann eine vereinfachte und platzsparende Steuervorrichtung für einen Elektromotor und dergleichen bereitgestellt werden.

Die vorliegende Erfindung wird nun anhand der beigefügten Zeichnungen näher erläutert, in denen zeigen:
- FIG 1: eine klassische Kaskode gemäß dem Stand der Technik;
- FIG 2: eine alternative Kaskode gemäß dem Stand der Technik;
- FIG 3: zwei parallele Kaskoden jeweils entsprechend FIG 1;
- FIG 4: zwei parallele Kaskoden jeweils gemäß FIG 2;
- FIG 5: eine Halbbrückenschaltung mit zwei Kaskoden jeweils gemäß FIG 1;
- FIG 6: eine Halbbrückenschaltung mit zwei Kaskoden jeweils gemäß FIG 2;
- FIG 7: eine Kaskodenschaltungsanordnung mit zwei parallelen selbstleitenden Schaltelementen auf der Basis der Kaskode von FIG 1;
- FIG 8: eine Kaskodenschaltungsanordnung mit zwei parallelen selbstleitenden Schaltelementen auf der Basis der Kaskode gemäß FIG 2;

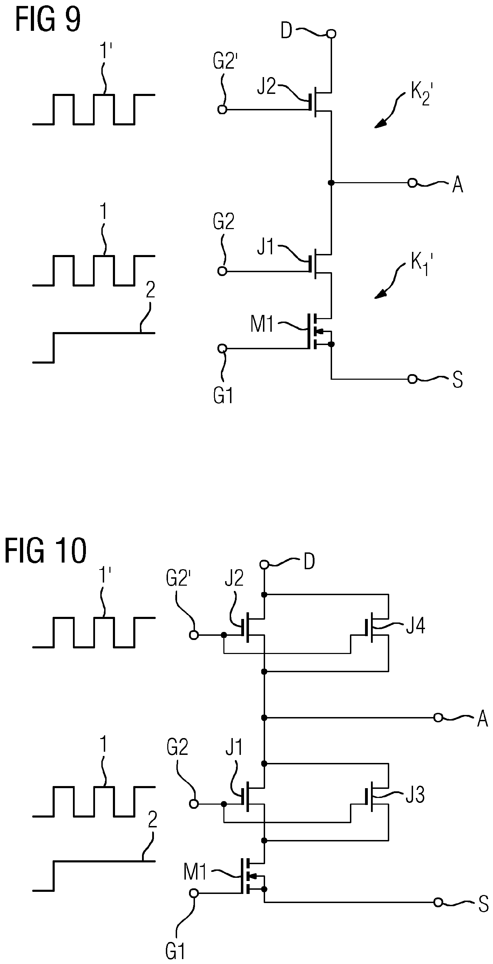

- FIG 9: eine Kaskodenhalbbrücke mit einem einzigen MOSFET; und
- FIG 10: die Kaskodenhalbbrücke von FIG 9 mit parallelen JFETs.

Die nachfolgend näher geschilderten Ausführungsbeispiele stellen bevorzugte Ausführungsformen der vorliegenden Erfindung dar.

Bei Parallelschaltung von Kaskoden zur Erhöhung der Gesamtstromtragfähigkeit wurden bisher genauso viele selbstsperrende Schaltelemente (insbesondere MOSFETs) wie selbstleitende Schaltelemente (insbesondere JFETs) benötigt. Dies wurde im Zusammenhang mit den FIG 1 bis 4 erläutert. Ähnliches gilt für die Serienschaltung von zwei Kaskoden für Halbbrückenschaltungen. Diesbezüglich wird auf die Erläuterungen zu den FIG 5 und 6 hingewiesen.

Erfindungsgemäß werden nun zwei Kaskoden derart miteinander verschaltet, dass mindestens ein selbstsperrendes Schaltelement eingespart werden kann. Somit kann eine Kaskodenschaltungsanordnung bereitgestellt werden, bei der das selbstsperrende Schaltelement sowohl zur ersten Kaskode als auch zur zweiten Kaskode gehört. Im einfachsten Fall besitzt die Kaskodenschaltungsanordnung also zwei selbstleitende Schaltelemente und ein einziges selbstsperrendes Schaltelement. In weiteren Ausbaustufen können weitere selbstleitende Schaltelemente hinzu kommen. Gegebenenfalls kann auch ein weiteres selbstsperrendes Schaltelement hinzu kommen, solange die Anzahl der selbstleitenden Schaltelemente größer ist als diejenige der selbstsperrenden Schaltelemente.

In den folgenden Ausführungen ist stets von MOSFETs und JFETs die Rede. Diese Bezeichnungen gelten aber stellvertretend für beliebige andere selbstsperrende Schaltelemente beziehungsweise selbstleitende Schaltelemente.

Durch die neuartige Verschaltung der JFETs können beliebig viele JFETs mit nur einem einzigen MOSFET gesteuert werden, der dann allerdings den Gesamtstrom führen muss. Hierbei werden alle Source-Potentiale der JFETs zusammengefasst und auf das Drain des MOSFET geschaltet. In den FIG 7 bis 10 sind hierzu einige Beispiele dargestellt.

Die Kaskodenschaltungsanordnung gemäß FIG 7 besitzt eine erste Kaskode K1 und eine zweite Kaskode K2. Beide Kaskoden sind ähnlich wie in FIG 3 parallel geschaltet. Die erste Kaskode besitzt einen MOSFET M1 in Serie mit einem JFET J1 zwischen Drain D und Source S der Kaskodenschaltungsanordnung. Die Steuerelektrode von MOSFET M1 entspricht dem Gate G der Kaskodenschaltungsanordnung. Die zweite Kaskode K2 besitzt einen zweiten JFET J2 und nutzt als selbstsperrendes Schaltelement den MOSFET M1 der ersten Kaskode K1. Demnach ist der einzige MOSFET M1 der Kaskodenschaltungsanordnung sowohl der ersten Kaskode K1 als auch der zweiten Kaskode K2 zugeordnet. Dabei liegen die Steuerelektroden der JFETs J1 und J2 am Source S. Die Leistungspfade der beiden JFETs J1 und J2 sind parallel geschaltet. Ein Schaltsignal 1 wird an Gate G gelegt. Sobald der MOSFET M1 durchgeschaltet wird, folgen die selbstleitenden JFETs J1 und J2. Die Funktionsweise entspricht also im Wesentlichen der Kaskodenschaltungsanordnung von FIG 3, wobei auf einen MOSFET verzichtet wurde.

Die Kaskodenschaltungsanordnung gemäß FIG 8 entspricht der erfindungsgemäß vereinfachten Schaltungsanordnung von FIG 4. Auch hier ist eine erste Kaskode K1 mit einer zweiten Kaskode K2 parallel geschaltet. Auch hier teilen sich die beiden Kaskoden K1 und K2 den einzigen MOSFET M1. Die Leistungspfade der beiden JFETs J1 und J2 der Kaskoden K1 und K2 sind ebenfalls parallel geschaltet.

Die Steuerelektrode des einzigen MOSFET M1 stellt ein erstes Gate G1 der Kaskodenschaltungsanordnung dar und wird mit einem Ersteinschaltsignal 2 versorgt. Darüber hinaus sind die Steuerelektroden der beiden JFETs J1 und J2 zusammengelegt und repräsentieren das zweite Gate G2 der Kaskodenschaltungsanordnung. Dieses zweite Gate G2 wird mit dem Schaltsignal 1 gespeist. Die Funktionsweise entspricht somit prinzipiell der Funktionsweise der Schaltung von FIG 4.

In Anlehnung an die Halbbrückenschaltung von FIG 5 wird nun erfindungsgemäß eine Halbbrücke mit zwei Kaskoden K1 und K2 gemäß FIG 9 bereitgestellt. Der JFET J1 in Serie mit dem MOSFET M1 bilden die erste Kaskode K1 und der zweite JFET J2 bildet zusammen mit dem einzigen MOSFET M1 die zweite Kaskode K2'. Ein Knotenpunkt zwischen Drain des ersten JFET J1 und Source des zweiten JFET J2 bildet den Ausgang A der Kaskodenschaltungsanordnung. Die Steuerelektrode des einzigen selbstsperrenden MOSFET M1 entspricht dem ersten Gate G1, die Steuerelektrode des ersten JFET J1 einem zweiten Gate G2 und die Steuerelektrode des zweiten JFET J2 einem weiteren Gate G2' der Kaskodenschaltungsanordnung. Gate G1 erhält das Ersteinschaltsignal 2, Gate G2 erhält das Schaltsignal 1 und Gate G2' erhält ein weiteres Schaltsignal 1'. Die beiden Schaltsignale 1 und 1' sind grundsätzlich unabhängig voneinander, können aber auch voneinander abhängig gemacht werden. Die Funktionsweise dieser Kaskodenschaltungsanordnung gemäß FIG 9 entspricht prinzipiell der von FIG 6.

In FIG 10 ist eine Weiterentwicklung der Kaskodenschaltungsanordnung von FIG 9 dargestellt. Der prinzipielle Schaltungsaufbau beider Kaskodenschaltungsanordnungen ist gleich. Lediglich besitzen in der Ausführungsform gemäß FIG 10 die beiden JFETs J1 und J2 jeweils parallele JFETs J3 und J4. So sind die beiden JFETs J2 und J4 parallel geschaltet, insbesondere deren Leistungspfade. Die Steuerelektroden der beiden JFETs J2 und J4 sind zusammengeschaltet und bilden das weitere Gate G2'. Ähnliches gilt für die beiden JFETs J1 und J3. Ihre Leistungspfade sind parallel geschaltet und ihre Steuerelektroden sind zusammengeschaltet und bilden das zweite Gate G2. Somit ergibt sich eine erste Kaskode mit J1 und M1, eine zweite Kaskode mit J2 und M1, eine dritte Kaskode mit J3 und M1 sowie eine vierte Kaskode mit J4 und M1. Damit teilen sich sämtliche selbstleitenden JFETs J1 bis J4 einen einzigen gemeinsamen MOSFET M1.

Erfindungsgemäß ergibt sich also die Möglichkeit, durch Parallelschaltung von JFETs die Stromtragfähigkeit des Gesamtschalters zu erhöhen, ohne die Anzahl der erforderlichen MOSFETs in gleichem Maße zu erhöhen. Darüber hinaus kann man in der Anwendung in der Brückenschaltung mit nur einem einzigen MOSFET die erforderlichen Sperreigenschaften der Halbbrücke realisieren. Ist es aufgrund höherer Stromtragfähigkeit erforderlich, mehrere JFETs parallel zu schalten, ist trotzdem z.B. nur ein einziger MOSFET in Summe für die gesamte Halbbrücke erforderlich. Insbesondere reicht der einzige MOSFET zum Sperren des Lowside-Schalters, um Brückenkurzschluss zu verhindern. Dadurch ergibt sich ein erhebliches Einsparpotential durch die Reduzierung der erforderlichen MOSFETs. Hieraus resultieren neben Kosteneinsparungen auch Platzeinsparungen aufgrund der reduzierten Anzahl an selbstsperrenden Schaltelementen. Bei Modulaufbauten sind entsprechend kleine Module möglich. Aufgrund der Einsparungen sind außerdem Steigerungen der Leistungsdichte möglich. Ferner kann eine Verbesserung der Gesamtzuverlässigkeit durch die Einsparung von Bondverbindungen erreicht werden, da weniger Bauteile weniger Verbindungen erfordern. Gegebenenfalls muss ein größerer MOSFET eingesetzt werden, da dieser den Gesamtstrom tragen muss.

## Patentansprüche

1. Kaskodenschaltungsanordnung mit
- einer ersten Kaskode (K1), die ein erstes selbstleitendes Schaltelement (J1) in Serie mit einem selbstsperrenden Schaltelement (M1) aufweist, und
- einem zweiten selbstleitenden Schaltelement (J2),
**dadurch gekennzeichnet, dass**
- das selbstsperrende Schaltelement (M1) das einzige selbstsperrende Schaltelement der Kaskodenschaltungsanordnung ist und
- das zweite selbstleitende Schaltelement (J2) mit dem einzigen selbstsperrenden Schaltelement (M1) eine von der ersten verschiedenen zweite Kaskode (K2) bildet.

2. Kaskodenschaltungsanordnung nach Anspruch 1, wobei das selbstsperrende Schaltelement (M1) ein MOSFET ist.

3. Kaskodenschaltungsanordnung nach Anspruch 1 oder 2, wobei jedes selbstsperrende Schaltelement (J1, J2) ein JFET ist.

4. Kaskodenschaltungsanordnung nach einem der vorhergehenden Ansprüche, wobei jedes selbstsperrende Schaltelement (J1, J2) ein GaN-Bauelement ist.

5. Kaskodenschaltungsanordnung nach einem der vorhergehenden Ansprüche, wobei das erste selbstleitende Schaltelement (J1) und das zweite selbstleitende Schaltelement (J2) bezüglich ihrer Leistungspfade parallel geschaltet sind.

6. Kaskodenschaltungsanordnung nach Anspruch 5, wobei eine jeweilige Steuerelektrode jedes selbstleitenden Schaltelements (J1, J2) an Source (S) der Kaskodenschaltungsanordnung gelegt ist und eine Steuerelektrode des selbstsperrenden Schaltelements (M1) als einziger Steuereingang (G) der Kaskodenschaltungsanordnung ausgebildet ist.

7. Kaskodenschaltungsanordnung nach Anspruch 5, wobei eine jeweilige Steuerelektrode jedes selbstleitenden Schaltelements (J1, J2) an einen zweiten Steuereingang (G2) der Kaskodenschaltungsanordnung gelegt ist und eine Steuerelektrode des selbstsperrenden Schaltelements (M1) an einen von dem zweiten Steuereingang verschiedenen ersten Steuereingang (G1) der Kaskodenschaltungsanordnung gelegt ist.

8. Kaskodenschaltungsanordnung nach einem der Ansprüche 1 bis 4, wobei das erste selbstleitende Schaltelement (J1) und das zweite selbstleitende Schaltelement (J2) bezüglich ihrer Leistungspfade in Serie geschaltet sind.

9. Kaskodenschaltungsanordnung nach Anspruch 8, wobei eine Steuerelektrode des ersten selbstleitenden Schaltelements (J1) einen zweiten Steuereingang (G2) der Kaskodenschaltungsanordnung, eine Steuerelektrode des zweiten selbstleitenden Schaltelements (J2) einen weiteren Steuereingang (G2') der Kaskodenschaltungsanordnung und eine Steuerelektrode des selbstsperrenden Schaltelements (M1) einen ersten Steuereingang zum An- und Abschalten der beiden selbstleitenden Schaltelemente (J1, J2) darstellen.

10. Steuervorrichtung für einen Elektromotor mit einer Kaskodenschaltungsanordnung nach einem der vorhergehenden Ansprüche.
